(19) Europäisches Patentamt

European Patent Office

Office européen des brevets

(11) **EP 0 942 291 B1**

(12) **EUROPÄISCHE PATENTSCHRIFT**

(45) Veröffentlichungstag und Bekanntmachung des Hinweises auf die Patenterteilung:
**24.05.2006 Patentblatt 2006/21**

(51) Int Cl.:
*G01R 31/02* *(2006.01)*    *G01B 7/06* *(2006.01)*

(21) Anmeldenummer: **99102925.7**

(22) Anmeldetag: **13.02.1999**

(54) **Vorrichtung zur Messung der Kapazität von elektrischen Adern**

Measuring device of the capacitance of electrical conductors

Dispositif de mesure de la capacité de conducteurs électriques

(84) Benannte Vertragsstaaten:
**AT CH DE GB LI**

(30) Priorität: **07.03.1998 DE 19809890**

(43) Veröffentlichungstag der Anmeldung:
**15.09.1999 Patentblatt 1999/37**

(73) Patentinhaber: **SIKORA INDUSTRIEELEKTRONIK GMBH**
**D-28307 Bremen (DE)**

(72) Erfinder: **Sikora, Harald**
**28357 Bremen (DE)**

(74) Vertreter: **Hauck, Graalfs, Wehnert, Döring, Siemons**
**Neuer Wall 41**
**20354 Hamburg (DE)**

(56) Entgegenhaltungen:
**EP-A- 0 394 525    EP-A- 0 679 863**
**US-A- 3 812 424**

**Beschreibung**

Die Erfindung bezieht sich auf eine Vorrichtung zur Messung der Kapazität von elektrischen Adern nach dem Oberbegriff des Patentanspruchs 1.

Bei der Herstellung von elektrischen Adern, die aus einem Leiter und einer isolierenden Ummantelung bestehen, ist es für den Hersteller wichtig, die Kapazität des Kabels zu messen. Bekanntlich bestimmt die Kapazität die Höhe des Wellenwiderstands.

Aus GB 2 003 613 ist bekannt, die Kapazität eines Kabels dadurch zu messen, daß ein Meßrohr aus elektrisch leitendem Material vorgesehen ist, durch das das Kabel hindurchgeführt wird. Das Meßrohr ist vorzugsweise in der Kühlstrecke angeordnet und mithin mit Wasser gefüllt. Das Meßrohr wird mit einer hochfrequenten Meßspannung beaufschlagt, wobei der Leiter an Erde liegt. Dadurch fließt ein Strom zwischen dem Meßrohr und dem Leiter, der abhängig ist von der Dielektrizität des Isoliermaterials sowie von seiner Dicke.

Aus EP 0 679 863 ist auch bekannt, dieses Meßprinzip zur Messung der exzentrischen Verlagerung des Leiters eines Kabels im Kabelmantel zu messen. Zu diesem Zweck sind drei am Umfang des Kabels versetzt angeordnete kreisbogenförmige auf einem Kreis um das Kabel angeordnete, gegeneinander isolierte elektrisch leitende Elektrodensegmente vorgesehen, die jeweils an hochfrequente Meßspannung gelegt werden. Der zu den einzelnen Elektrodensegmenten fließende Strom ist ein Maß für die Dicke des Kabelmantels im Bereich des Elektrodensegments. Sind daher die Ströme, die zu den einzelnen Elektrodensegmenten fließen, nicht gleich, ist dies ein Anzeichen dafür, daß der Leiter nicht mehr konzentrisch im Kabelmantel liegt.

Aus EP 0 394 525 A ist ein Verfahren und eine Vorrichtung zum Überprüfen der Isolation von isolierten elektrischen Leitern sowie zur Erkennung und Klassifizierung von Isolationsfehlern beschrieben. Bei dem bekannten Verfahren läuft das Kabel axial durch mindestens zwei hintereinander liegende zylinderförmige Sonden, die jeweils Kondensatoren mit dem Leiter des Kabels als Gegenpol bilden. Die Sonden, d. h. die Kondensatoren werden mittels einer Hochspannungsquelle derart aufgeladen, daß bei Fehlern in der Isolation der Kondensator von einem Durchschlagstrom kurzgeschlossen wird. Durch Erfassen dieser Durchschläge und deren Auswertung an den einzelnen Sonden werden ortsspezifische Signale in Korrelation mit dem Vorschub des Kabels gewonnen.

Aus US 3,812,424 A ist eine Vorrichtung zur kapazitiven Messung der Dicke eines Drahtes beschrieben. Der Draht wird durch eine zylinderförmige Meßelektrode und zwei koaxial beabstandete Abschirmelektroden bewirkt. Der kapazitive Strom wird zur Ermittlung der Drahtdicke ausgewertet.

Insbesondere bei mit hoher Frequenz betriebenen elektrischen Adern, beispielsweise bis 2 GHz, spielen auch lokale Änderungen in der Kapazität entlang der Ader, die durch inhomogenen Kabelaufbau oder durch Änderungen in den Dickenabmessungen verursacht werden, eine Rolle. Solche Änderungen verursachen unerwünschte Reflexionen der elektromagnetischen Wellen.

Der Erfindung liegt daher die Aufgabe zugrunde, eine Vorrichtung zur Messung der Kapazität von elektrischen Adern zu schaffen, mit der auf einfache Weise auch örtliche Änderungen in der Kapazität der Ader ermittelt werden können.

Diese Aufgabe wird durch die Merkmale des Patentanspruchs 1 gelöst.

Bei der erfindungsgemäßen Vorrichtung ist koaxial und in Reihe zu einem ersten Meßrohr ein zweites Meßrohr angeordnet, dessen Länge deutlich kürzer ist als die Länge des ersten Meßrohres. Das erste Meßrohr, das auch aus einer Summe von Einzelrohrstücken zusammengesetzt sein kann, muß aus Gründen der Genauigkeit für die Kapazitätsmessung eine Mindestlänge aufweisen, beispielsweise 200 mm. Eine derartige Länge ermöglicht jedoch keine ausreichende Auflösung, um Kapazitätsschwankungen in kleineren Bereichen zu ermitteln. Daher ist ein zweites deutlich kürzeres Meßrohr vorgesehen, das etwa 10 bis 25% der gesamten Länge von erstem und zweitem Meßrohr betragen oder - in absoluten Zahlen - zwischen 20 und 50 mm lang sein kann. Mit Hilfe von Strommessungen wird die Kapazität zwischen dem ersten Meßrohr und dem Leiter und die Kapazität zwischen dem zweiten Meßrohr und dem Leiter gemessen. Es ist auch möglich, bezüglich der ersten Kapazitätswerte erstes und zweites Meßrohr zusammen zu nehmen und die Kapazität zwischen diesem und dem Leiter zu bestimmen.

Dem ersten und zweiten Meßrohr kann eine separate Strommeßvorrichtung zugeordnet werden, und eine geeignete Auswertevorrichtung wertet vorkommende Stromschwankungen und -änderungen aus und gibt sie als Kapazitätsänderungen bzw. -schwankungen an. Erreichen die Änderungen bzw. Schwankungen kritische Werte, kann eine entsprechende Anzeige vorgenommen werden. Ggf. ist ein Kabelabschnitt als unbrauchbar zu entfernen.

Bei der allgemeinen Kapazitätsmessung kann das zweite Meßrohr außen vor bleiben. Alternativ kann es auch mit herangezogen werden, indem z.B. die Ströme zum ersten und zweiten Meßrohr addiert werden. In diesem Fall kann eine Strommeßvorrichtung auch den gesamten zu beiden Meßrohren fließenden Strom ermitteln. Die Heranziehung des zweiten Meßrohrs zur Kapazitätsmessung hat den Vorteil, daß die gesamte Länge der erfindungsgemäßen Vorrichtung nicht größer zu sein braucht als diejenige für die herkömmliche Kapazitätsmessung.

Es versteht sich, daß auch zwei oder mehr zweite Meßrohre vorgesehen werden können, die ggf. unterschiedliche Länge haben, um den jeweils gewünschten Auflösungsgrad zu erzielen. Zwar wird die Ortsauflösung mit kürzer werdender Meßelektrode größer, andererseits steigen Störeffekte mit geringer werdender Länge an, so daß die Gefahr besteht, daß bei besonders kurzen zweiten Meßrohren kaum noch auswertbare Meßergebnisse erhalten werden.

Bei einer besonderen Ausführungsform der Erfindung ist das zweite Meßrohr zwischen mindestens zwei Abschnitten des ersten Meßrohrs angeordnet. Eine derartige Anordnung hat den Vorteil, daß die auf das zweite Meßrohr wirkenden Störfelder minimal sind, mithin besonders präzise Schwankungen in der Kapazität gemessen werden können.

Vorzugsweise hat das zweite Meßrohr den gleichen Durchmesser wie das erste Meßrohr, und beide Meßrohre werden vorzugsweise von einem gemeinsamen Abschirmrohr umgeben. Zwischen Abschirmrohr und den Meßrohren kann eine Isolation aus festem Material vorgesehen werden, die beide Teile zu einem gemeinsamen Körper verbindet. Zusätzlich kann ein zweites, an Masse liegendes Abschirmrohr das erste Abschirmrohr umgeben und ebenfalls mit den anderen Teilen eine Einheit ergeben.

Die Erfindung wird nachfolgend anhand von in Zeichnungen dargestellten Ausführungsbeispielen näher erläutert.

Fig. 1    zeigt im Schnitt schematisch eine erste Ausführungsform einer Vorrichtung nach der Erfindung.

Fig. 2    zeigt äußerst schematisch eine zweite Ausführungsform nach der Erfindung.

Fig. 3    zeigt schematisch eine Schaltungsanordnung für eine Kapazitätsmessung.

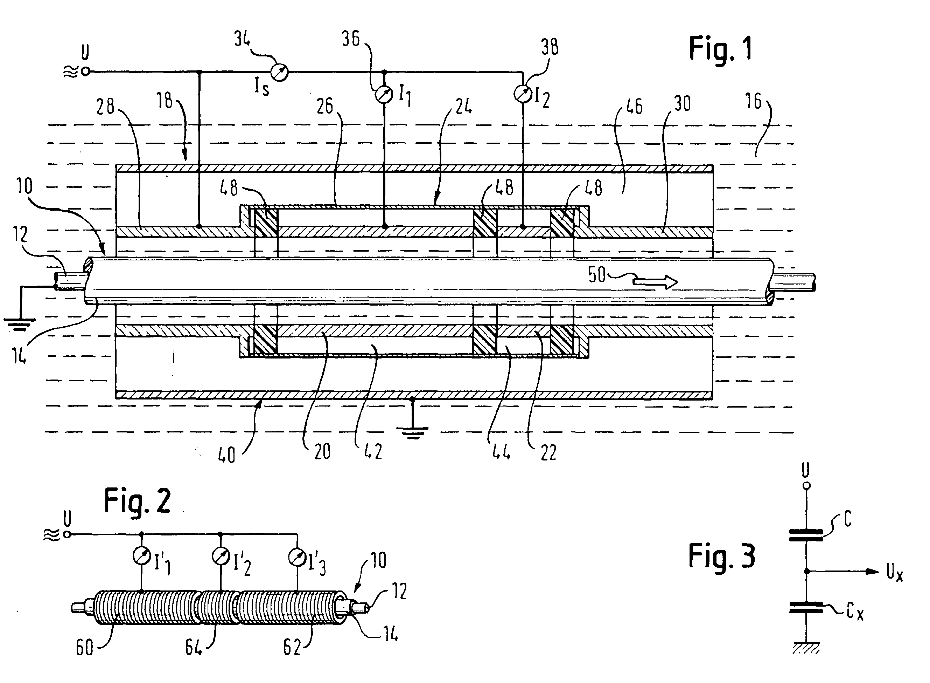

In Fig. 1 ist eine Ader 10 dargestellt, die aus einem Leiter 12 und einem Mantel 14 aus isolierendem Material besteht und die durch ein Wasserbad 16 in der Kühlstrecke einer nicht gezeigten Kabel-Fertigungsanlage geführt ist. Im Wasserbad 16 befindet sich auch ein Meßkörper 18. Er weist ein erstes Meßrohr 20 auf, das zum Beispiel eine Länge von 200 mm aufweist. Im kurzen Abstand zum ersten Meßrohr 20 ist ein zweites Meßrohr 22 von gleichem Durchmesser angeordnet, z.B. von einer Länge von 25 mm. Die Meßrohre 20, 22, die aus elektrisch leitendem Material bestehen, sind von einem Abschirmrohr 24 aus leitendem Material in radialem Abstand umgeben. Das Abschirmrohr 24 weist einen mittleren Abschnitt 26 auf, der die Meßrohre 20, 22 im radialen Abstand umgibt sowie zwei Endabschnitte 28, 30, die einen geringeren Durchmesser aurweisen, der etwa dem Durchmesser der Meßrohre 20, 22 entspricht. Die Meßrohre 20, 22 und das Abschirmrohr 24 liegen an einer hochfrequenten Meßspannung U, z.B. 450 kHz. Die Spitzenspannung beträgt zum Beispiel 20 V. In der Leitung zu den Meßrohren 20, 22 ist eine erste Strommeßvorrichtung 34 vorgesehen. In der Leitung zum ersten Meßrohr 20 ist eine zweite Strommeßvorrichtung 36 und in der Leitung zum zweiten Meßrohr 22 eine dritte Strommeßvorrichtung 38 vorgesehen. Der Leiter 12 ist an Masse gelegt, ebenso wie ein zweites Abschirmrohr 40, das das erste Abschirmrohr 24 im radialen Abstand umgibt. Zwischen den Meßrohren 20, 22 einerseits und dem ersten Abschirmrohr 24 andererseits liegt eine Isolierschicht 42 bzw. 44, die jedoch nicht besonders eingezeichnet ist. Sie kann auch aus Luft bestehen. Zwischen dem Abschirmrohr 24 und dem Abschirmrohr 40 ist eine Isolierschicht 46 angeordnet. Hier gilt das gleiche wie zu 42. Die beschriebenen Teile sind miteinander verbunden und bilden somit den einheitlichen Meßkörper 18. Zwischen den Isolierschichten 42, 44 und zwischen diesen und dem Isolierkörper 46 sind ringförmige Isolierteile 48 angeordnet.

Beim Anlegen der Meßspannung fließt ein Strom von den Meßrohren 20, 22 zum Leiter 12. Der Strom ist ein Maß für die Kapazität der Ader 10. Werden die Ströme 11 und 12 der Meßvorrichtungen 36, 38 addiert, ist ein Maß für die Kapazität erhalten. Sie kann auch dadurch gemessen werden, daß die Strommeßvorrichtung 34 den Strom $I_s$ mißt. Der Strom 12 der Meßvorrichtung 38 ändert sich, wenn bei der Vorwärtsbewegung der Ader 10 in Richtung Pfeil 48 die Kapazität sich vorübergehend ändert, mithin eine lokale Kapazitätsänderung vorliegt. Gemessene Stromschwankungen geben mithin Kapazitätsschwankungen wieder, die unter Umständen kritisch sind, weil sie auf der produzierten Ader später zu starken Reflexionen der elektromagnetischen Wellen führen.

In Fig. 2 ist sehr schematisch eine andere Anordnung von Meßrohren angedeutet. In Fig. 2 erkennt man zwei Meßrohrabschnitte 60, 62, die zusammen eine Länge von etwa 200 mm ergeben. Sie sind jedoch in einem gewissen Abstand zueinander angeordnet. Dazwischen ist ein kurzer Meßrohrabschnitt 64 angeordnet, beispielsweise von einer Länge von 20 bis 50 mm. Die Meßrohrabschnitte 60 bis 64 sind wiederum an eine hochfrequente Meßspannung U angeschlossen, wie dies anhand von Fig. 1 erläutert wurde. In der jeweiligen Leitung zu den Meßrohrabschnitten 60, 62 ist jeweils eine Strommeßvorrichtung angeordnet, welche die Ströme I'1, I'2 und I'3 messen. Die Summe dieser Ströme kann zur Kapazitätsmessung herangezogen werden. Die Schwankungen des Stroms I'2 sind ein Indikator für Kapazitätsschwankungen.

Es versteht sich, daß bei der Anordnung nach Fig. 2 eine ähnliche Konstruktion gewählt werden kann, wie sie in Fig. 1 angedeutet ist. Daher sind die Abschirmrohre nicht eingezeichnet.

Die Schaltungsanordnung nach Fig. 3 zeigt einen Kondensator C bekannter Kapazität, der in Reihe liegt zu dem Kondensator $C_x$, der zwischen einem Meßrohrabschnitt, z.B. Abschnitt 20 oder Abschnitt 22 und dem Leiter 12 gebildet ist und dessen Kapazität gemessen werden soll. Die Reihenschaltung liegt an der Hochfrequenzspannung U, deren Wert ebenfalls bekannt ist. An einem Punkt zwischen den Kondensatoren

C und $C_x$ wird die Spannung $U_x$ gemessen. Demnach ist die zu bestimmende Kapazität $C_x$ aus folgender Formel berechenbar:

$$C_x = \frac{(U - U_x) \cdot C}{U_x}$$

## Patentansprüche

1. Vorrichtung zur Messung der Kapazität von elektrischen Adern, die aus einem inneren Leiter (12) und einem Isolationsmantel (14) bestehen, mit einem aus mindestens einem Stück bestehenden Meßrohr (20, 60, 62) aus elektrisch leitendem Material, das mit einer hochfrequenten Meßspannungsquelle verbunden ist und durch das die Ader (10) hindurch bewegt wird, wobei sich zwischen der Ader (10) und dem Meßrohr (20, 60, 62) Wasser (16) befindet, einem Abschirmrohr (24), das das Meßrohr (20) in radialem Abstand umgibt und ebenfalls an der Meßspannung liegt, und einer mit dem Meßrohr (20, 60, 62) verbundenen ersten Strommeßvorrichtung (36), die zum Zwecke der Kapazitätsbestimmung den zwischen Meßrohr (20, 60, 62) und Ader (10) fließenden Strom mißt, **dadurch gekennzeichnet, daß** in kurzem Abstand zum ersten Meßrohr mindestens ein zweites Meßrohr (22, 64) koaxial und in Reihe zum ersten Meßrohr (20, 60, 62) vorgesehen ist, dessen Länge deutlich kürzer ist als die Länge des ersten Meßrohrs und das ebenfalls mit der Meßspannungsquelle verbunden und von dem Abschirmrohr (24) umgeben ist und eine mit dem zweiten Meßrohr (22) verbundene zweite Strommeßvorrichtung (38) vorgesehen ist, die den Strom zwischen dem zweiten Meßrohr (22) und der Ader (10) mißt und eine Auswertevorrichtung für den Strom der ersten und zweiten Strommeßvorrichtung (38) vorgesehen ist zur Anzeige von Kapazität und lokalen Kapazitätsschwankungen längs der Ader.

2. Vorrichtung nach Anspruch 1, **dadurch gekennzeichnet, daß** eine dritte Strommeßvorrichtung (34) den Summenstrom aus den Strömen zwischen dem ersten Meßrohr (20) und dem zweiten Meßrohr (22) und dem Leiter (12) mißt.

3. Vorrichtung nach Anspruch 1, **dadurch gekennzeichnet, daß** erstes und zweites Meßrohr (20, 22, 60, 62, 64) gleichen Durchmesser aufweisen.

4. Vorrichtung nach einem der Ansprüche 1 bis 3, **dadurch gekennzeichnet, daß** das zweite Meßrohr (64) zwischen zwei Abschnitten (60, 62) des ersten Meßrohrs angeordnet ist.

5. Vorrichtung nach einem der Ansprüche 1 bis 4, **dadurch gekennzeichnet, daß** das zweite Meßrohr (22, 64) eine Länge aufweist, die zwischen 10 und 25% der gemeinsamen Länge von erstem und zweitem Meßrohr liegt.

6. Vorrichtung nach Anspruch 5, **dadurch gekennzeichnet, daß** die Gesamtlänge von erstem und zweitem Meßrohr ca. 200 mm beträgt.

7. Vorrichtung nach Anspruch 5 oder 6, **dadurch gekennzeichnet, daß** die Länge des zweiten Meßrohrs (22, 64) 20 bis 50 mm beträgt.

8. Vorrichtung nach einem der Ansprüche 1 bis 7, **dadurch gekennzeichnet, daß** das Abschirmrohr (24) mit Abschnitten (28, 30) über die Meßrohre (20, 22) hinaussteht, wobei die Abschnitte (28, 30) annähernd den gleichen Durchmesser wie die Meßrohre (20, 22) aufweisen.

9. Vorrichtung nach einem der Ansprüche 1 bis 8, **dadurch gekennzeichnet, daß** das Abschirmrohr (24) von einem zweiten Abschirmrohr (40) im radialen Abstand umgeben ist, das an Masse gelegt ist.

10. Vorrichtung nach einem der Ansprüche 1 bis 9, **dadurch gekennzeichnet, daß** die Meßrohre (20, 22) und das Abschirmrohr (24) einen gemeinsamen Körper (18) bilden und durch eine Isolationsschicht (42, 44) miteinander verbunden sind.

## Claims

1. A device for measuring the capacitance of electrical wires consisting of an inner conductor (12) and an insulating cover (14), the device comprising a measuring tube (20, 60, 62) made of electrically conductive material and consisting of at least one portion, being connected to a measuring voltage source of high frequency, the wire (10) being moved through said measuring tube, wherein water (16) is provided between the wire (10) and the measuring tube (20, 60, 62), a shielding tube (24) surrounding the measuring tube (20) in a radial spacing and being also connected to the measuring voltage, and a first current measuring device (36) connected to the measuring tube (20, 60, 62), the current measuring device measuring the current flowing between the measuring tube (20, 60, 62) and the wire (10) in order to determine the capacitance, **characterized in that** at least one second measuring tube (22, 64) is provided co-axially and in a row with respect to the first measuring tube (20, 60, 62) and in a short spacing thereof, the length of which is significantly shorter than the length of the first measuring tube and which is also connected to the measuring voltage source and surrounded by the shielding tube (24), and a second current measuring device (38) is provided which is connected to the second measuring tube (22), and which is measuring the current flowing between the second measuring tube (22) and the wire (10) and an evaluation device is provided to evaluate the currents of the first and second current measuring devices (38) for indicating the capacitance and local capacitance changes along the wire.

2. The device of claim 1, **characterized in that** a third current measuring device (34) is provided measuring the total current of the currents between a first measuring tube (20) and the second measuring tube (22) and the conductor (12).

3. The device of claim 1, **characterized in that** first and second measuring tubes (20, 22, 60, 62, 64) have the same diameter.

4. The device of any of the claims 1 to 3, **characterized in that** the second measuring tube (64) is provided between two sections (60, 62) of the first measuring tube.

5. The device of any of the claims 1 to 4, **characterized in that** the second measuring tube (22, 64) has a length between 10 and 25 % of the total length of the first and second measuring tubes.

6. The device of claim 5, **characterized in that** the total length of the first and second measuring tubes is approximately 200 mm.

7. The device of claim 5 or 6, **characterized in that** the length of the second tube (22, 64) is 20 - 50 mm.

8. The device of any of the claims 1 to 7, **characterized in that** the shielding tube (24) extends with sections (28, 30) beyond the measuring tubes (20, 22), wherein the sections (28, 30) have approximately the same diameter as the measuring tubes (20, 22).

9. The device of any of the claims 1 to 8, **characterized in that** the shielding tube (24) is surrounded in a radial spacing by a second shielding tube (40) which is connected to ground.

10. The device of any of the claims 1-9, **characterized in that** the measuring tubes (20, 22) and the shielding tube (24) form a common body and are connected to each other by an insulating layer (42, 44).

**Revendications**

1. Dispositif de mesure de la capacité de conducteurs électriques qui se composent d'un conducteur interne (12) et d'une gaine isolante (14), avec un tube de mesure (20, 60, 62), composé d'au moins une pièce, en matériau électriquement conducteur, qui est connecté à une source de tension de mesure haute fréquence et à travers lequel est déplacé le conducteur (10), de l'eau (16) se trouvant entre le conducteur (10) et le tube de mesure (20, 60, 62), d'un tube de blindage (24) qui entoure le tube de mesure (20) à une distance radiale et est également connecté à la tension de mesure, et un premier dispositif de mesure de courant (36) connecté au tube de mesure (20, 60, 62) et qui mesure le courant s'écoulant entre le tube de mesure (20, 60, 62) et le conducteur (10) afin de déterminer la capacité, **caractérisé en ce que**, à une faible distance du premier tube de mesure, il est prévu au moins un deuxième tube de mesure (22, 64) de façon coaxiale et en série avec le premier tube de mesure (20, 60, 62), et dont la longueur est nettement plus courte que la longueur du premier tube de mesure et qui est également connecté à la source de tension de mesure et est entouré du tube de blindage (24), et **en ce qu'**il est prévu un deuxième dispositif de mesure de courant (38) connecté au deuxième tube de mesure (22) et qui mesure le courant entre le deuxième tube de mesure (22) et le conducteur (10), et **en ce qu'**il est prévu un dispositif d'analyse pour le courant du premier et du deuxième dispositifs de mesure de courant (38) pour l'indication de la capacité et de variations locales de la capacité le long du conducteur.

2. Dispositif selon la revendication 1, **caractérisé en ce qu'**un troisième dispositif de mesure de courant (34) mesure le courant cumulé issu des courants entre le premier tube de mesure (20) et le deuxième tube de mesure (22) et le conducteur (12).

3. Dispositif selon la revendication 1, **caractérisé en ce que** le premier et le deuxième tubes de mesure (20, 22, 60, 62, 64) présentent le même diamètre.

4. Dispositif selon une des revendications 1 à 3, **caractérisé en ce que** le deuxième tube de mesure (64) est disposé entre deux tronçons (60, 62) du premier tube de mesure.

5. Dispositif selon une des revendications 1 à 4, **caractérisé en ce que** le deuxième tube de mesure (22, 64) présente une longueur qui se situe entre 10 et 25 % de la longueur commune du premier et du deuxième tubes de mesure.

6. Dispositif selon la revendication 5, **caractérisé en ce que** la longueur totale du premier et du deuxième tube de mesure est d'environ 200 mm.

7. Dispositif selon la revendication 5 ou 6, **caractérisé en ce que** la longueur du deuxième tube de mesure (22, 64) est de 20 à 50 mm.

8. Dispositif selon une des revendications 1 à 7, **caractérisé en ce que** le tube de blindage (24) dépasse au-dessus des tubes de mesure (20, 22) par des tronçons (28, 30), les tronçons (28, 30) présentant approximativement le même diamètre que les tubes de mesure (20, 22).

9. Dispositif selon une des revendications 1 à 8, **caractérisé en ce que** le tube de blindage (24) est entouré, à une distance radiale, d'un deuxième tube de blindage (40) qui est mis à la masse.

10. Dispositif selon une des revendications 1 à 9, **caractérisé en ce que** les tubes de mesure (20, 22) et le tube de blindage (24) forment un corps commun (18) et sont raccordés entre eux par une couche isolante (42, 44).

Fig. 1

Fig. 2

Fig. 3